# EUROPEAN PATENT SPECIFICATION

(11) **EP 2 469 586 B1**
(45) Date of publication and mention of the grant of the patent: **08.01.2020**
(21) Application number: 11190878.6
(22) Date of filing: 28.11.2011
(51) Int. Cl.: B28D 5/04, B26D 1/30, B26D 3/06, H01L 21/67

(54) **Patterning device**
Strukturiervorrichtung
Dispositif de placement de motif

(30) Priority: 24.12.2010 JP 2010287449; 07.09.2011 JP 2011194593
(43) Date of publication of application: 27.06.2012
(73) Proprietor: Mitsuboshi Diamond Industrial Co., Ltd., Suita-shi, Osaka 564-0044 (JP)
(72) Inventor: Soyama, Masanobu, Suita-city, Osaka 564-0044 (JP)
(74) Representative: TBK

(56) References cited:
- WO-A1-2007/018041
- US-A1- 2005 081 988
- US-A1- 2006 037 694
- US-A1- 2008 261 351

## Description

The present invention relates to a patterning device for partially peeling off or removing a film formed on a substrate according to the preamble of claim 1.

### Description of the Background Art

A conventionally known technique of peeling off a film formed on a surface of a CIGS (copper indium gallium diselenide)-based solar cell by pressing a blade edge against the surface of the solar cell to form a groove (patterning) is disclosed for example in WO 2009/145058 A1. For example, this technique is
implemented via a process of peeling off or removing a relatively wide range of a film formed on a lower electrode at an end portion of a substrate for a solar cell in order to expose the lower electrode (this process is called a shaving off process).

In a manufacturing process of solar cells, various heat treatments are performed before the aforementioned patterning. However, these heat treatments may generate warpage of a substrate (glass substrate) forming a solar cell, thereby to prevent the blade length direction of a blade edge and a surface of the substrate from being substantially parallel to each other. Warpage of a substrate is not serious if a narrow groove is to be formed with a narrow patterning tool. However, the aforementioned shaving off process involves removal of a wide portion, requiring a patterning tool with a wide blade edge. In this case, warpage of a substrate makes it impossible for a blade edge to contact a film on a substrate uniformly, so a peeled off or removed portion of the film will not have a desired width.

US 2005/081988 A1 shows a patterning device for partially peeling off or removing a film formed on a substrate.

This patterning device comprises a holding unit tor Holding a substrate on which a film is formed; a patterning tool with a blade edge at a tip end portion of the patterning tool, the blade edge extending in a blade length direction; a holder for fixing said patterning tool; a holder swinging section for holding said holder while making the holder rotatable about a first axis existing in a plane including processing direction and vertical direction; a driving section for causing said holder swinging section to move relative to said holding unit; and a lifting section for moving said holder swinging section up and down.

WO 2007/018041 A1 shows a generic patterning device for partially peeling off or removing a film formed on a substrate according to the preamble of claim 1. This generic patterning device comprises a holding unit for holding a substrate on which a film is formed; a patterning tool with a blade edge at a tip end portion of the patterning tool, the blade edge extending in a blade length direction; a holder for fixing said patterning tool; a holder swinging section for holding said holder while making the holder rotatable; and a driving section for causing said holder swinging section to move relative to said holding unit.

### SUMMARY OF THE INVENTION

It is an object of the present invention to further develop a generic patterning device for partially peeling off or removing a film formed on a substrate according to the preamble of claim 1 such that processing quality of peeling off or removing the film formed on the substrate by means of the patterning device is improved.

The object of the present invention is achieved by a patterning device for partially peeling off or removing a film formed on a substrate having the features of claim 1.

Further advantageous developments according to the present invention are defined in the dependent claims.

Even if a film targeted for patterning has a tilt in the blade length direction for some reason such as warpage of the substrate, the posture of the blade edge of the patterning tool can be changed in response to the tilt, making it possible to stably form a groove of a desired width.

The above and other features, aspects and advantages of the present invention will become more apparent from the following detailed description of the present invention when taken in conjunction with the accompanying drawings.

### BRIEF DESCRIPTION OF THE DRAWINGS

Fig. 1 is a front view of an exemplary overall structure of a patterning device 1;
Fig. 2 is a side view of the exemplary overall structure of the patterning device 1;
Fig. 3 is a front view of an exemplary structure of a solar cell 3;
Fig. 4 is a front view of exemplary structures of a patterning head 30 and its vicinities;
Fig. 5 is a side view of exemplary structures of a holder swinging section 34 and its vicinities;
Fig. 6 is a side view of the condition of the patterning head 30 observed when the patterning head 30 performs patterning;
Fig. 7 is a front view of the structure of a patterning tool 60;
Fig. 8 is a front view showing exemplary positions of the patterning tool 60 and a substrate 4 with a film 5 with respect to each other;
Fig. 9 shows a relationship between the posture of the patterning tool 60 and a groove 6;
Fig. 10 is a front view of a patterning tool 160 of a modification;
Fig. 11 shows exemplary application of the patterning tool 160 to patterning by the patterning device 1; and
Figs. 12 and 13 are front views of the structures of patterning tools 260 and 360 respectively according to modifications.

### DESCRIPTION OF THE PREFERRED EMBODIMENTS

### <Overall Structure of Patterning device>

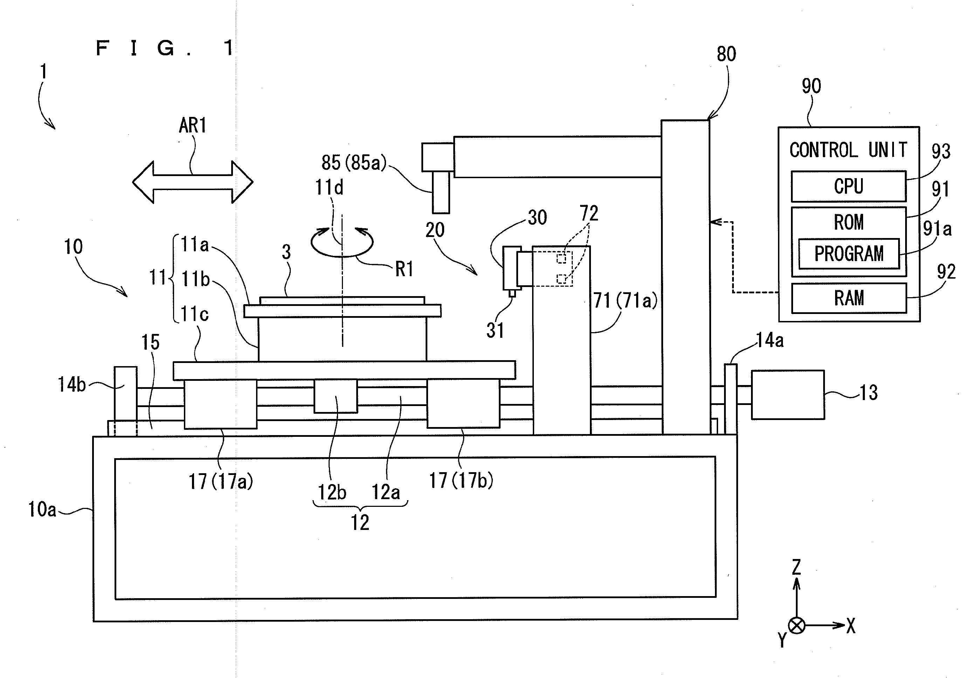

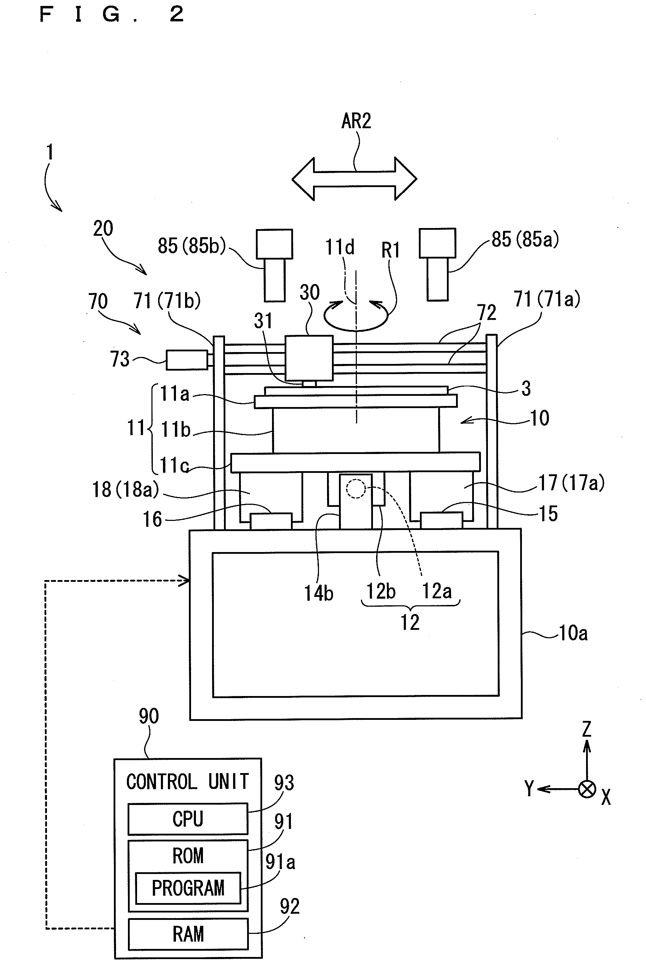

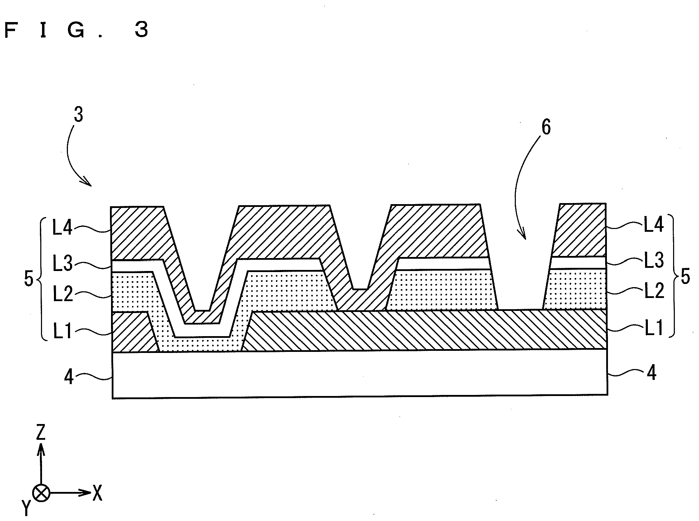

Figs. 1 and 2 are front and side views respectively of an exemplary overall structure of a patterning device 1. Fig. 3 is a front view of an exemplary structure of a solar cell 3 as a main target of patterning by the patterning device 1. Fig. 1 and its following figures include an XYZ orthogonal coordinate system intended to clearly show the directions of the figures with respect to each other. The XYZ orthogonal coordinate system shows the Z-axis direction corresponding to a vertical direction, and the XY plane corresponding to a horizontal plane. In a preferred embodiment, the Y-axis positive direction is a direction in which patterning proceeds (direction in which processing proceeds), unless otherwise specified.

If intended for a solar cell 3 shown in Fig. 3 with a substrate 4 and a film 5 formed on the substrate 4, for example, the patterning of the preferred embodiment means formation of a groove 6 in the film 5 by causing a tool to peel off the film 5 (see Fig. 3), or exposure of a specific film such as that of a metallic back (lower) electrode.

The substrate 4 is a glass substrate or a ceramics substrate made of a brittle material, or a substrate made of a flexible material such as a resin film. In the preferred embodiment, the substrate 4 with the film 5 formed thereon but without the groove 6, namely a target of patterning may simply be called a substrate 4.

As shown in Fig. 3, the film 5 of the solar cell 3 includes a metallic back (lower) electrode L1, a CIGS (Cu, In, Ga, Se) light absorbing layer L2, a buffer layer L3, and a transparent contact window layer L4.

Patterning to form the groove 6 is implemented by removing the CIGS light absorbing layer L2, the buffer layer L3, and the transparent contact window layer L4, after the metallic back electrode L1, the CIGS light absorbing layer L2, the buffer layer L3, and the transparent contact window layer L4 are stacked in this order. A groove may also be formed before formation of the transparent contact window layer L4 by removing the CIGS light absorbing layer L2 and the buffer layer L3. Formation of the groove 6 exposes the metallic back electrode L1.

Referring back to Figs. 1 and 2, the patterning device 1 mainly includes a holding unit 10, a patterning unit 20, an image capturing unit 80, and a control unit 90.

The holding unit 10 holds the substrate 4 constituting the solar cell 3, and causes the substrate 4 held on the holding unit 10 to move relative to the patterning unit 20. The holding unit 10 is arranged on a base part 10a, and which mainly includes a table 11, a ball screw mechanism 12, and a motor 13 as shown in Fig. 1.

The base part 10a is made of a stone surface plate that is substantially a rectangular parallelepiped, and the upper surface thereof (surface facing the holding unit 10) is flattened. This reduces thermal expansion of the base part 10a, allowing the substrate 4 held on the holding unit 10 to move satisfactorily.

The table 11 holds the substrate 4 under suction placed thereon. The table 11 causes the substrate 4 held on it to move back and forth in the direction of arrows AR1 (X-axis positive or negative direction which may also be called "back-and-forth direction" simply), and causes the substrate 4 to rotate in the direction of arrows R1. As shown in Figs. 1 and 2, the table 11 mainly includes a suction part 11a, a rotary table 11b, and a rolling table 11c.

The suction part 11a is provided over the rotary table 11b. The substrate 4 can be placed on the upper surface of the suction part 11a as shown in Figs. 1 and 2. Multiple suction slots (not shown) are formed in a lattice pattern in the upper surface of the suction part 11a. So, discharge (suction) of air from each of the suction slots while the substrate 4 is placed on the suction part 11a makes the substrate 4 be held under suction on the suction part 11a.

The rotary table 11b is provided under the suction part 11a, and which causes the suction part 11a to rotate about a rotary axis 11d that is substantially parallel to the Z-axis. The rolling table 11c is provided under the rotary table 11b, and which causes the suction part 11a and the rotary table 11b to move in the back-and-forth direction.

Thus, the substrate 4 held under suction on the table 11 is caused to move back and forth in the direction of arrows AR1, and is caused to rotate about the rotary axis 11d in response to the back and forth movement of the suction part 11a.

The ball screw mechanism 12 is arranged below the table 11, and which causes the table 11 to move back and forth in the direction of arrows AR1. The ball screw mechanism 12 mainly includes a feed screw 12a and a nut 12b as shown in Figs. 1 and 2.

The feed screw 12a is a rod extending in the back-and-forth direction of the table 11. A spiral groove (not shown) is formed in the outer circumference of the feed screw 12a. One end of the feed screw 12a is supported on a supporting part 14a and the opposite end thereof is supported on a supporting part 14b, in a rotatable manner, respectively. The feed screw 12a is communicatively coupled to the motor 13. So, the rotation of the motor 13 causes the feed screw 12a to rotate in a direction in which the motor 13 rotates.

The nut 12b moves back and forth in the direction of arrows AR1 with rolling of a bearing ball not shown under the rotation of the feed screw 12a. The nut 12b is fixed on a lower part of the rolling table 11c as shown in Figs. 1 and 2.

Thus, if the motor 13 is actuated and the torque of the motor 13 is transmitted to the feed screw 12a, the nut 12b moves back and forth in the direction of arrows AR1. In response, the table 11 to which the nut 12b is fixed moves back and forth together with the nut 12b in the direction of arrows AR1.

A pair of guide rails 15 and 16 regulates the movement of the table 11 in the back-and-forth direction. As shown in Fig. 2, the pair of guide rails 15 and 16 is fixed on the base part 10a while being separated from each other in the direction of arrows AR2 by a certain distance.

Multiple (in the preferred embodiment, two) sliding parts 17 (17a and 17b) are freely slidable along the guide rail 15 in the direction of arrows AR1. As shown in Figs. 1 and 2, the sliding parts 17 are fixed on a lower part of the rolling table 11c while being separated from each other in the direction of arrows AR1 by a certain distance.

Multiple (in the preferred embodiment, two) sliding parts 18 are freely slidable along the guide rail 16 in the direction of arrows AR1. Only a sliding part 18a is shown in Figs. 1 and 2 due to space limitations. Like the sliding parts 17, the sliding parts 18 are fixed on a lower part of the rolling table 11c while being separated from each other in the direction of arrows AR1 by a certain distance.

As described above, the table 11 moves along the pair of guide rails 15 and 16 depending on the giving of the torque of the motor 13 to the ball screw mechanism 12, providing ability of the table 11 to move straight in the back-and-forth direction.

The patterning unit 20 is responsible for patterning to form the grooves 6 in the film 5 formed on the substrate 4. As shown in Figs. 1 and 2, the patterning unit 20 mainly includes a patterning head 30 and a driving section 70.

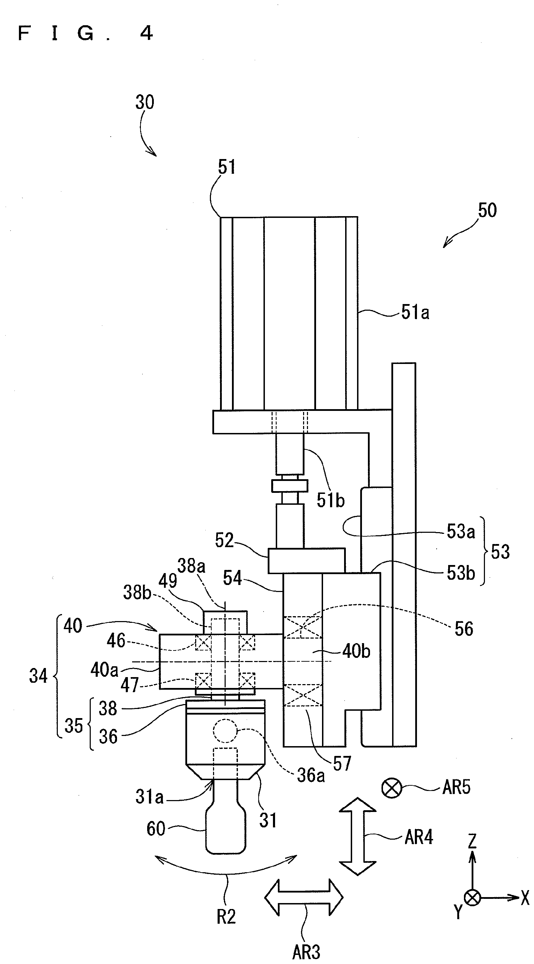

The patterning head 30 includes a patterning tool 60 (see Fig. 4) that actually contacts the film 5 during patterning to peel off or remove the film 5. In the preferred embodiment, the patterning head 30 is caused to move relative to the substrate 4 held on the holding unit 10 while the patterning tool 60 is brought into abutting contact with a position to be patterned of the film 5. As a result, the film 5 on the substrate 4 is peeled off or removed with the patterning tool 60 to form the groove 6. The specific structure of the patterning head 30 and a patterning process by the patterning head 30 are described later.

The driving section 70 causes a holder 31 (see Fig. 4) to which the patterning tool 60 is attached to move relative to the holding unit 10, thereby causing the patterning tool 60 to reciprocate in the direction of arrows AR2 (Y-axis positive or negative direction which may also be called "processing direction" simply). The driving section 70 mainly includes multiple (in the preferred embodiment, two) column supports 71 (71a and 71b), multiple (in the preferred embodiment, two) guide rails 72, and a motor 73 as shown in Fig. 2.

The column supports 71 (71a and 71b) extend vertically (in the Z-axis direction) from the base part 10a. The guide rails 72 are fixed between the column supports 71a and 71b.

The guide rails 72 regulate the movement of the patterning head 30 in the processing direction. As shown in Fig. 2, the guide rails 72 are fixed between the column supports 71a and 71b while being separated one above the other by a certain distance.

The motor 73 is communicatively coupled to a feed mechanism (such as a ball screw mechanism) not shown. So, in response to the rotation of the motor 73, the patterning head 30 reciprocates along the guide rails 72 in the direction of arrows AR2.

The image capturing unit 80 captures an image of the substrate 4 held on the holding unit 10. As shown in Fig. 2, the image capturing unit 80 includes multiple (in the preferred embodiment, two) cameras 85 (85a and 85b).

The cameras 85 are arranged above the holding unit 10 as shown in Figs. 1 and 2. The cameras 85 capture images of characteristic portions (such as an alignment mark not shown) formed on the substrate 4. The position and the posture of the substrate 4 are determined based on the images captured by the cameras 85.

The control unit 90 is responsible for operational control for respective elements in the patterning device 1, and data arithmetic. As shown in Figs. 1 and 2, the control unit 90 mainly includes a ROM 91, a RAM 92, and a CPU 93.

The ROM (read-only memory) 91 is what is called a nonvolatile storage for storing a program 91a, for example. The ROM 91 may be a nonvolatile flash memory allowing writing and reading to and from the memory. The RAM (random-access memory) 92 is a volatile storage for storing data used for the arithmetic in the CPU 93, for example.

The CPU (central processing unit) 93 is responsible for control according to the program 91a in the ROM 91 (including control of the up and down movement of a holder swinging section 34 caused by a lifting section 50, and control of the reciprocating movement of the patterning head 30 caused by the driving section 70). The CPU 93 is also responsible for data processing such as calculation of the position of the substrate 4.

### <Outline of Structure of Patterning Head>

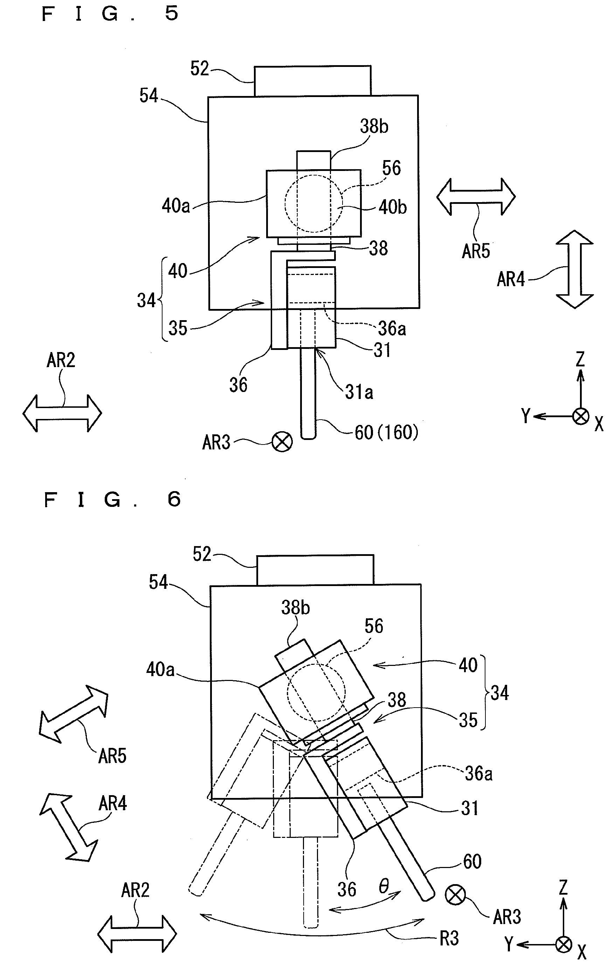

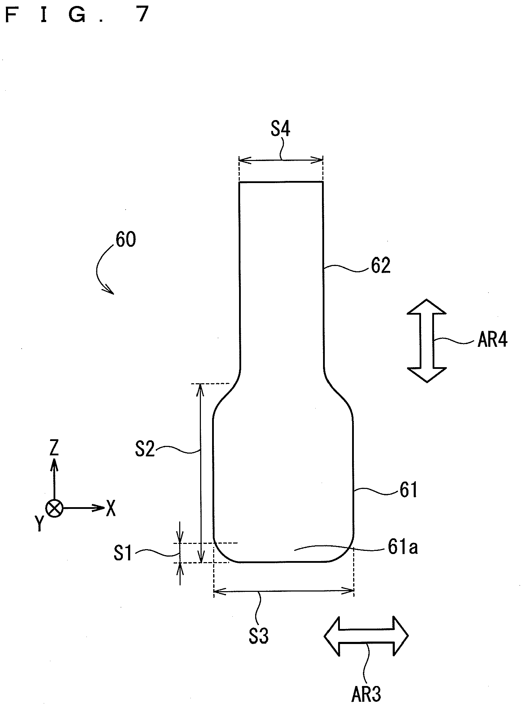

Fig. 4 is a front view of exemplary structures of the patterning head 30 and its vicinities. Fig. 5 is a side view of exemplary structures of the holder swinging section 34 and its vicinities. Note that Figs. 4 and 5 show the conditions of the patterning head 30 or part of the patterning head 30 at the time when the patterning head 30 does not perform patterning. Fig. 6 is a side view of the condition of the patterning head 30 observed when the patterning head 30 performs patterning. Fig. 7 is a front view of the structure of the patterning tool 60. A phrase "resting condition" appearing in the description given below means a condition where the patterning device 1 does not perform patterning.

As shown in Figs. 4 to 6, the patterning head 30 mainly includes the patterning tool 60, the holder 31 in which the patterning tool 60 is fixedly held, the holder swinging section 34 for allowing the swinging movement of the holder 31 with fixing the patterning tool 60, and the lifting section 50 for controlling the height of the patterning tool 60.

The patterning tool 60 partially peels off or removes the film 5 to form the groove 6 (see Fig. 3). The patterning tool 60 is generally made of a hard material such as cemented carbide and a sintered body of diamond. The patterning tool 60 mainly includes a blade part 61 and a gripping part 62 as shown in Fig. 7.

The patterning tool 60, or at least the blade part 61 of it, is formed into a flat plate as shown in Figs. 4 to 7. Further, the blade part 61 has a blade edge 61a extending in the blade length direction (direction of arrows AR3) at its tip end portion. By referring to Figs. 4 to 7, a direction (direction of arrows AR4) along a surface of the blade part 61 and substantially perpendicular to the blade length direction is defined as a tool longitudinal direction.

The blade edge 61a is rounded off in order to maintain a contact region with the film 5 and to enhance abrasion resistance. It is preferable that a size S1 of the blade edge 61a (chamfered portions thereof) in the tool longitudinal direction is in a range of from 0.3 mm to 2 mm (more preferably, from 0.5 mm to 1 mm). A size S2 across the blade edge 61a in the tool longitudinal direction is preferably in a range of from 2 mm to 20 mm (more preferably, from 3 mm to 10 mm). Further, the size S3 of the blade part 61 in the blade length direction is preferably from 1 mm to 15 mm (more preferably, from 2 mm to 10 mm).

The gripping part 62 is in the form of a flat plat, and which extends from the blade part 61 in the tool longitudinal direction (in the direction of arrows AR4) as shown in Fig. 7. The patterning tool 60 is fixed to the holder 31 by insertion of an end portion and its vicinity of the gripping part 62 into a fixing hole 31a formed in the holder 31.

As shown in Fig. 7, the size S3 (third size) of the blade edge 61a in the blade length direction is greater than the size S4 of the gripping part 62 in the same blade length direction. This is intended to increase the width of the groove 6 to be formed by one processing to its maximum width.

The size S4 of the gripping part 62 in the blade length direction is preferably in a range of from 0.5 mm to 12 mm (more preferably, from 1 mm to 8 mm).

The patterning tool 60 of the aforementioned structure is fixed to the holder 31 for patterning. The patterning tool 60 can be fixed to the holder 31 in various ways; of which fixation with a screw is preferred as it provides simple and stable fixation.

More specifically, as shown in Figs. 4 and 5, the patterning tool 60 is fixed to the holder 31 such that the tool longitudinal direction is substantially the same as the vertical direction (Z-axis direction), and that the blade length direction of the blade edge 61a is substantially perpendicular to the processing direction (Y-axis direction) of the groove 6 in the resting condition.

### <Holder Swinging Section and Lifting Section>

The holder 31 fixing the patterning tool 60 is held by the holder swinging section 34. The holder swinging section 34 is held by the lifting section 50.

More specifically, as shown in Figs. 4 to 6, the holder swinging section 34 mainly includes a holder joint 35 the holder 31 is attached to, and a holder attachment block 40 for attachment of the holder joint 35 to the lifting section 50. The holder joint 35 includes an attachment strip 36 and a turning part 38. The holder attachment block 40 includes bearings 46 and 47, and a fixing portion 49.

The attachment strip 36 is an element of the holder joint 35 to which the holder 31 is directly attached. The attachment strip 36 is provided at a lower end portion of the holder joint 35 as shown in Figs. 4 to 6.

The attachment strip 36 is provided with a fixing axis 36a the holder 31 is attached to. The fixing axis 36a extends in a direction (direction of arrows AR5) substantially perpendicular to the longitudinal direction of the patterning tool 60, and besides substantially perpendicular to the blade length direction of the blade edge 61a when the holder 31 is attached to the fixing axis 36a. The direction substantially perpendicular to the blade length direction of the blade edge 61a will also be called an "axial direction" simply. The axial direction is the same as the Y-axis direction in the resting condition.

The turning part 38 connects the holder joint 35 to the holder attachment block 40. The turning part 38 is journaled in the bearings 46 and 47 of the holder attachment block 40. To be specific, the turning part 38 is inserted into a main body 40a of the holder attachment block 40 such that the turning part 38 faces the inner surfaces of the bearings 46 and 47. This allows the holder joint 35 to rotate about a rotary axis 38a extending in a direction substantially parallel to the longitudinal direction of the patterning tool 60. The bearings 46 and 47 in the main body 40a of the holder attachment block 40 are arranged one above the other in this order in the resting condition. Thus, the direction in which the rotary axis 38a of the turning part 38 extends is the same as the Z-axis direction in the resting condition.

Provision of the turning part 38 allows the holder joint 35 to rotate about the rotary axis 38a of the turning part 38. The rotary axis 38a exists in a plane including the processing direction and the vertical direction. So, in other words, the holder joint 35 is capable of rotating about an axis existing in a plane including the processing direction and the vertical direction. The fixing portion 49 for regulating the rotation of the turning part 38 is provided at a tip end portion 38b of the turning part 38. So, the swinging movement of the holder joint 35 is actually limited to a predetermined angular range about the rotary axis 38a.

The description of the preferred embodiment is based on the assumption that the two bearings 46 and 47 are used. However, the number of bearings is not limited to two, but it may alternatively be one, or three or more.

The lifting section 50 is connected to the holder attachment block 40 of the holder swinging section 34, and which causes the holder swinging section 34 holding the holder 31 to move up and down in the Z-axis direction as a whole. As shown in Fig. 4, the lifting section 50 mainly includes a cylinder 51 and a transmission part 52.

The cylinder 51 supplies driving force applied for causing the holder swinging section 34 to move up and down (in the Z-axis positive or negative direction). As shown in Fig. 4, the cylinder 51 is provided above the holder attachment block 40, and which mainly includes a main body 51a and a rod 51b.

The rod 51b is capable of moving toward and away from the main body 51a. The lower end of the rod 51b is coupled to the transmission part 52 as shown in Fig. 4. So, actuation of the cylinder 51 causes the rod 51b to move away from the main body 51a, making the lower end of the rod 51b press the transmission part 52 downward.

The transmission part 52 is provided between the cylinder 51 and the holder attachment block 40 of the holder swinging section 34, and transmits driving force from the cylinder 51 to the holder attachment block 40.

As shown in Fig. 4, a guide mechanism 53 mainly includes a guide rail 53a, and a guide block 53b capable of sliding up and down along the guide rail 53a. The guide block 53b is accompanied by an attachment plate 54 the holder attachment block 40 is directly attached to. The attachment plate 54 is given an insertion hole 56 to receive a pivot axis 40b of the holder attachment block 40, and a bearing 57 the rotary axis 40b is journaled in.

The insertion hole 56 extends in a direction parallel to the blade length direction of the patterning tool 60 that is namely a direction perpendicular to the processing direction in a horizontal plane. In response to insertion of the rotary axis 40b into the insertion hole 56, the bearing 57 allows the pivotal movement of the holder swinging section 34 about the pivot axis 40b. As shown in Fig. 5, or as indicated by alternate long and short dashed lines of Fig. 6, the position of the holder swinging section 34 in the resting condition is such that the longitudinal direction of the patterning tool 60 is the same as the vertical direction. The pivotal movement of the holder swinging section 34 about the pivot axis 40b is limited in a range of a predetermined angle θ by angle regulating means not shown. As an example, the holder swinging section 34 is capable of pivoting only in a range indicated by arrows R3 in Fig. 6. As a more specific example, it is preferable that the pivotal movement of the holder swinging section 34 be limited in a range of ±30 degrees with respect to the position of the holder swinging section 34 in the resting condition.

In response to insertion of the rotary axis 40b into the insertion hole 56, the holder swinging section 34 is also held by the guide block 53b through the attachment plate 54. With driving force applied from the cylinder 51, the guide block 53b is guided along the guide rail 53a in the guide mechanism 53, which realizes the up and down movement of the holder swinging section 34 in the Z-axis direction.

### <Patterning>

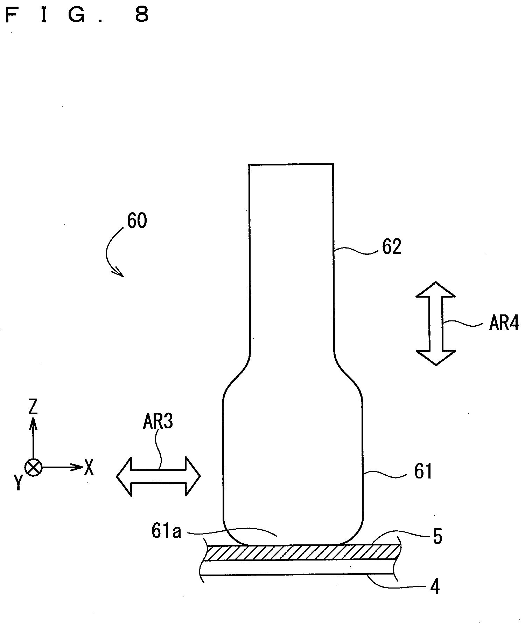

Patterning by the patterning device 1 of the aforementioned structure is described next. Fig. 8 is a front view showing exemplary positions of the patterning tool 60 and the substrate 4 with the film 5 with respect to each other.

As described above, in the patterning device 1 of the preferred embodiment, the holder swinging section 34 is capable of pivoting about the pivot axis 40b that is perpendicular to the processing direction in a horizontal plane, and the holder joint 35 is capable of rotating about the rotary axis 38a that is in a plane including the processing direction and the vertical direction. This allows patterning by the holder 31 fixing the patterning tool 60, with the holder 31 being capable of swinging about the two axes crossing each other at right angles. A relationship between the pivot axis 40b and the rotary axis 38a is such that the rotary axis 38a is in a plane perpendicular to the pivot axis 40b.

More specifically, while the substrate 4 is fixed under suction on the table 11, the blade edge 61a of the patterning tool 60 is made to abut on a position of the film 5 from which patterning is started (position from which formation of the groove 6 is started) as shown in Fig. 8. At this time, with actuation of the cylinder 51 under a certain thrust, a certain load is applied from the patterning tool 60 fixed to the holder 31 to the film 5 on the substrate 4. With the load acting on the film 5, the driving section 70 causes the patterning head 30 with the patterning tool 60 to move relative to the film 5. The posture of the blade edge 61a at the time when the blade length direction crosses the processing direction at right angles in a horizontal plane is called a reference posture.

When a processing direction proceeding from the starting position of patterning is the Y-axis positive direction, the holder swinging section 34 receives resistive force on its blade edge 61a from the film 5 in a direction (Y-axis negative direction) opposite the processing proceeding direction, although the holder swinging section 34 has such a posture in the resting condition that the longitudinal direction of the patterning tool 60 is the same as the vertical direction as shown in Fig. 5, or as indicated by alternate long and short dashed lines of Fig. 6. This resistive force becomes torque to cause the entire holder swinging section 34 to pivot about the pivot axis 40b, thereby placing the holder swinging section 34 to be in a posture tilted at an angle θ from the vertical direction as indicated by solid lines of Fig. 6. The movement of the patterning head 30 proceeds with the holder swinging section 34 being kept in this tilted posture.

At this time, as a matter of course, the patterning tool 60 is in a posture tilted at the angle θ from its posture in the resting condition. But, despite of this tilted posture, if the position control of the holder swinging section 34 in the Z-axis direction as described above is performed such that the patterning tool 60 applies a certain load to act on the film 5, the film 5 is peeled off or removed with the blade edge 61a of the patterning tool 60 while the patterning head 30 moves.

The description of patterning described so far is based on the assumption that the processing proceeding direction is the Y-axis positive direction. If the processing proceeding direction is the Y-axis negative direction opposite the Y-axis positive direction, the holder swinging section 34 may be placed in a tilted posture as indicated by alternate long and two short dashed lines of Fig. 6, thereby realizing processing in the same manner. So, for formation of multiple grooves 6 parallel to each other, for example, the processing proceeding direction may be changed in turn between the Y-axis positive and negative directions to realize reciprocating processing. In this processing, each time the processing proceeding direction is reversed, the holder swinging section 34 is placed in the tilted posture indicated by solid lines of Fig. 6 and that indicated by alternate long and two short dashed lines of Fig. 6 alternately. If there is no need for the reciprocating processing, the pivot axis 40b may be omitted and the holder swinging section 34 may be fixed at a certain angle θ.

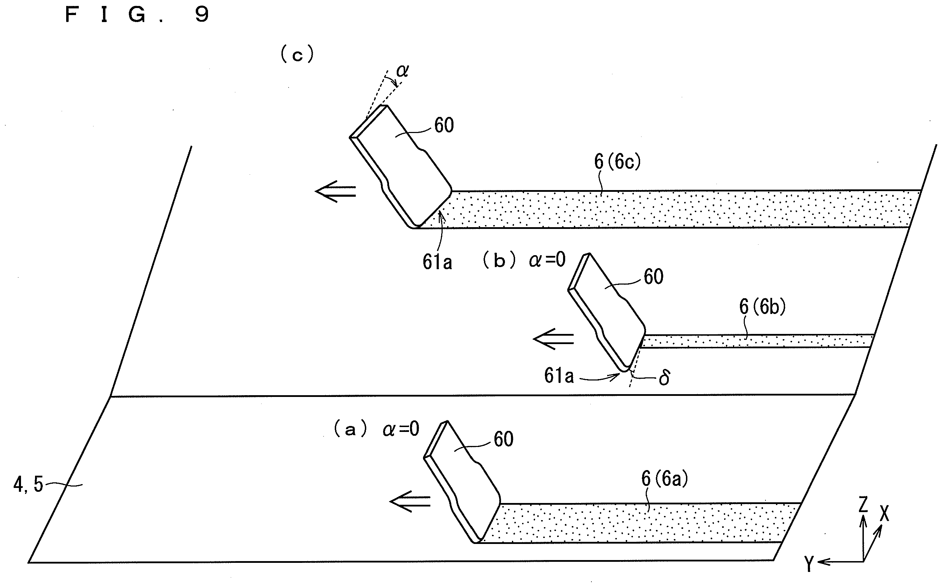

As already described above, the holder 31 for holding the patterning tool 60 is attached to the holder joint 35 that swings in a range of a predetermined angle about the rotary axis 38a, and therefore, the holder 31 keeps to be capable of swinging about the rotary axis 38a during patterning. So, if a position of the film 5 targeted for patterning is tilted around the Y-axis direction corresponding to the processing direction, the rotation of the holder 31 about the rotary axis 38a by an angle α places the patterning tool 60 in a posture responsive to the tilt. This is explained by referring to Fig. 9 showing a relationship between the posture of the patterning tool 60 and the groove 6.

If a position of the film 5 targeted for processing is parallel to the XY plane as shown in Fig. 9(a), the holder 31 is not required to rotate about the rotary axis 38a (α = 0). So, the blade edge 61a is kept in the reference posture. A groove 6 (6a) formed at this time has a width substantially the same as the size S3 of the patterning tool 60 in the blade length direction.

A position of the film 5 targeted for processing may be tilted from the Y-axis direction for some reason such as warpage of the substrate 4 as shown in Fig. 9(b). In this case, if the holder 31 does not rotate about the rotary axis 38a (α = 0) like in the case of Fig. 9(a), separation of an angle δ is generated between the blade edge 61a of the patterning tool 60 and the film 5 because the blade edge 61a is kept in the reference posture. This results in what is called one-sided contact where processing proceeds while only part of the blade edge 61a contacts the film 5. A groove 6 (6b) formed at this time has a width considerably smaller than the size S3 of the patterning tool 60 in the blade length direction.

In contrast, in the preferred embodiment, the holder 31 rotates about the rotary axis 38a by the angle α if a position of the film 5 targeted for processing is tilted around the Y-axis direction as shown in Fig. 9(c). This changes the posture of the blade edge 61a of the patterning tool 60 from the reference position, making substantially the entire blade edge 61a contact the film 5. A groove 6 (6c) formed at this time has a width sufficiently larger than that obtained in the case where the holder 31 does not rotate, though smaller than that obtained in the case where no tilt is generated in the film 5. While the tilt is shown exaggeratingly in Fig. 9 for the convenience of description, an actual tilt level (difference between recesses and projections) of the film 5 is as small as several hundreds of micrometers. So, from a practical point of view, the groove 6 formed by patterning with the swinging holder 31 has a substantially constant width. To be specific, even if the film 5 has a tilt in the blade length direction of the patterning tool 60, changing the posture of the blade edge 61a in response to the tilt allows formation of the groove 6 of a stable width.

As described above, the patterning device of the preferred embodiment realizes patterning of a film formed on a main surface of a substrate while allowing a patterning tool to swing about a rotary axis existing in a plane including the processing direction and the vertical direction. So, even if a film targeted for patterning has a tilt in the blade length direction for some reason such as warpage of the substrate, the posture of a blade edge of the patterning tool can be changed in response to the tilt, making it possible to stably form a groove of a desired width.

### <Modifications>

The present invention is not limited to the preferred embodiment described above, but various modifications of the present invention can be devised.

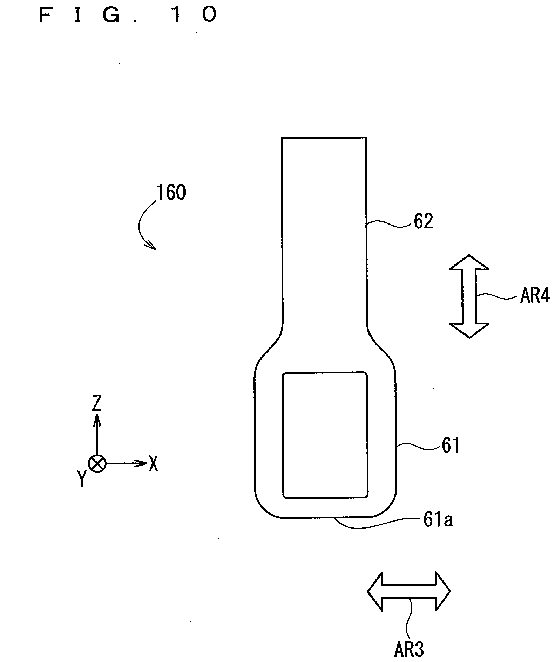

Fig. 10 is a front view of a patterning tool 160 of a modification. The patterning tool 160 shown in Fig. 10 is made of spring steel, and which has a through hole 61b formed in a blade part 61 corresponding to that of the patterning tool 60 of the preferred embodiment. This reduces the rigidity of a blade edge 61a in the patterning tool 160 compared to that in the patterning tool 60.

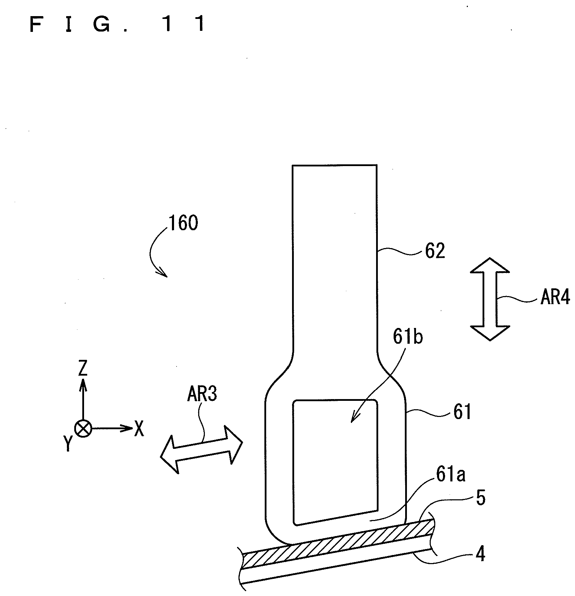

Fig. 11 shows exemplary application of the patterning tool 160 to patterning by the patterning device 1. In the patterning tool 160, the rigidity of the blade edge 61a is reduced for the provision of the through hole 61b. So, the blade edge 61a abutting on a film 5 is easily deformed in response to the shape of a main surface of a substrate 4. This allows the blade edge 61a to follow the main surface of the substrate 4 more easily than in the case of the preferred embodiment if the film 5 has a tilt for some reason such as warpage of the substrate 4, thereby more preferably preventing the partial contact of the blade edge 61a with the film 5 on the substrate 4.

Part of the film 5 peeled off or removed by patterning (processing dust) is passed through the through hole 61b in the blade part 61 toward a direction opposite the processing proceeding direction of the patterning tool 160. Thus, processing dust will not be present in the processing proceeding direction so it will not become an obstacle to patterning, or will not stick to the blade edge 61a, thereby allowing pattering with a higher degree of accuracy.

As long as the film 5 does not have large unevenness, use of the patterning tool 160 prevents partial contact even if swinging movement about the rotary axis 38a is not made.

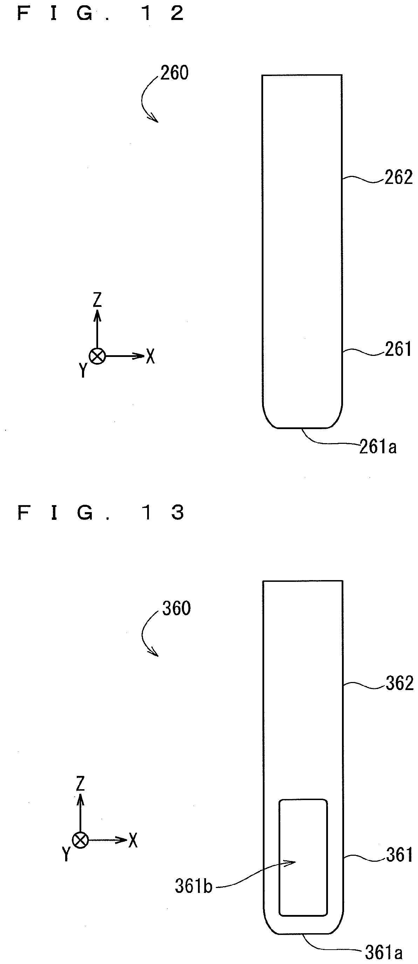

Figs. 12 and 13 are front views of the structures of patterning tools 260 and 360 respectively according to modifications. To be specific, patterning by the patterning device 1 may employ the patterning tool 260 shown in Fig. 12 with a blade part 261 and a gripping part 262 that are substantially the same in size in the blade length direction. Supposing that the size of the gripping part 262 in the blade length direction is substantially the same as the size S4 of the gripping part 62 of the patterning tool 60 in the same direction, the size of a blade edge 261a in the blade length direction is smaller than the size S3 of the blade edge 61a of the patterning tool 60 in the same direction. A patterning tool to be used can be selected according to the size of a groove 6 to be formed.

The patterning tool 360 shown in Fig. 13 has a through hole 361b formed in a blade part 61 corresponding to that of the patterning tool 160 of the aforementioned modification. The patterning tool 360 achieves the same effect as that of the patterning tool 160.

In the preferred embodiment described above, attachment of the holder 31 may also be such that the holder 31 is capable of swinging about the fixing axis 36a. To be specific, the holder 31 may swing in the direction of arrows R2 of Fig. 4. As an example, patterning with substantially no tilt of the patterning tool 60 may find difficulty in preventing one-sided contact by the swinging movement of the holder 31 about the rotary axis 38a. In contrast, one-sided contact can be prevented in such patterning with substantially no tilt of the patterning tool 60 if the holder 31 is capable of swinging about the fixing axis 36a.

The description of the preferred embodiment given above is based on the assumption that a target of peel-off or removal (patterning) by the patterning device 1 is the film 5 of the solar cell 3. However, this it not the only target of patterning by the patterning device 1. Patterning is performed satisfactorily if a target of patterning is a base part as a foundation (not limited to a substrate) with a film on the base part capable of being patterned.

The description of the preferred embodiment given above is based on the assumption that the patterning head 30 is caused to move during patterning by the driving section 70 in the processing direction (in the direction of arrows AR2) and relative to the holding unit 10. However, this is not the only way of patterning. As an example, the patterning head 30 may be fixed, and the holding unit 10 may be caused to move in the processing direction. Or, both the holding unit 10 and the patterning head 30 may be caused to move in the processing direction. To be specific, patterning is performed satisfactorily if at least one of the holding unit 10 and the patterning head 30 is caused to move relative to each other.

While the invention has been shown and described in detail, the foregoing description is in all aspects illustrative and not restrictive, i.e.
numerous modifications and variations can be devised without departing from the scope of the invention as defined by the appended claims.

A patterning device provided is capable of partially peeling off or removing a film formed on a substrate preferably. The patterning device includes a holder swinging section for holding a holder a patterning tool is fixed to while making the holder rotatable about a first axis existing in a plane including processing direction and vertical direction. The patterning tool performs patterning by causing the holder swinging section to move relative to the processing direction while making a blade edge of the patterning tool be in abutting contact with the film. During the patterning, the patterning tool is capable of swinging in combination of the rotation of the holder swinging section about the first axis. The swinging movement of the patterning tool is responsive to a tilt of the film in the blade length direction.

## Claims

1. A patterning device (1) for partially peeling off or removing a film (5) formed on a substrate (4), comprising:
a holding unit (10) for holding a substrate (4) on which a film (5) is formed;
a patterning tool (60) with a blade edge (61a) at a tip end portion of the patterning tool (60), the blade edge (61a) extending in a blade length direction (AR3);
a holder (31) for fixing said patterning tool (60);
a holder swinging section (34) for holding said holder (31) while making the holder (31) rotatable about a first axis (38a) existing in a plane including processing direction (AR2) and vertical direction (Z);
a driving section (70) for causing said holder swinging section (34) to move relative to said holding unit (10); and
a lifting section (50) for moving said holder swinging section (34) up and down;
said lifting section (50) being adapted to cause said holder swinging section (34) to move to get nearer said holding unit (10) such that said blade edge (61a) of said patterning tool (60) is in abutting contact with said film (5), and
said driving section (70) being adapted to cause said holder swinging section (34) to move relative to said processing direction (AR2) such that said film (5) is patterned by said patterning tool (60) in said processing direction (AR2),
the patterning device (1) being **characterized in that** said patterning tool (60) is adapted to swing in response to a tilt (δ) of said film (5) in said blade length direction (AR3) with the rotation of said holder (31) about said first axis (38a) in respect to a reference posture of said blade edge (61a), wherein the posture of said blade edge (61a) in case said blade length direction (AR3) crosses said processing direction (AR2) at right angles in a horizontal plane is defined as the reference posture.

2. The patterning device (1) according to claim 1, wherein said holder swinging section (34) is capable of pivoting about a second axis (40b) perpendicular to said processing direction (AR2) in a horizontal plane.

3. The patterning device (1) according to claim 2, wherein said patterning tool (60) is adapted to perform said patterning in a tilted posture in response to the pivotal movement of said holder swinging section (34) about said second axis (40b).

4. The patterning device (1) according to any one of claims 1 to 3, wherein said patterning tool (60) has a width (S3) in said blade length direction (AR3) greater than the width (S4) of part (62) of said patterning tool (1) fixed to said holder (31).

5. The patterning device (1) according to any one of claims 1 to 4, wherein said patterning tool (160, 360) has a through hole (61b, 361b) formed in an upper part (61, 361) of said blade edge (61a, 361a).

## Patentansprüche

1. Strukturiervorrichtung (1) zum teilweisen Ablösen oder Entfernen eines Films (5), der auf einem Substrat (4) ausgebildet ist, mit:
einer Halteeinheit (10) zum Halten eines Substrats (4), auf dem ein Film (5) ausgebildet ist;
einem Strukturierwerkzeug (60) mit einer Schneidenklinge (61a) an einem vorderen Endabschnitt des Strukturierwerkzeugs (60), wobei sich die Schneidenklinge (61a) in einer Schneidenlängsrichtung (AR3) erstreckt;
einer Halterung (31) zum Fixieren des Strukturierwerkzeugs (60);
einem Halterungsschwenkbereich (34) zum Halten der Halterung (31), während die Halterung (31) um eine erste Achse (38a), die in einer Ebene einschließlich einer Bearbeitungsrichtung (AR2) und einer senkrechten Richtung (Z) vorhanden ist, drehbar ist;
einem Antriebsbereich (70) zum Bewirken, dass sich der Halterungsschwenkbereich (34) relativ zu der Halteeinheit (10) bewegt; und
einem Hubbereich (50) zum Bewegen des Halterungsschwenkbereichs (34) nach oben und nach unten; wobei
der Hubbereich (50) angepasst ist, um zu bewirken, dass sich der Halterungsschwenkbereich (34) bewegt, um sich der Halteeinheit (10) derart anzunähern, dass die Schneidenklinge (61a) des Strukturierwerkzeugs (60) mit dem Film (5) in Anlagekontakt ist, und
der Antriebsbereich (70) angepasst ist, um zu bewirken, dass sich der Halterungsschwenkbereich (34) relativ zu der Bearbeitungsrichtung (AR2) bewegt, derart, dass der Film (5) durch das Strukturierwerkzeug (60) in der Bearbeitungsrichtung (AR2) strukturiert wird,
die Strukturiervorrichtung (1) **dadurch gekennzeichnet ist, dass**
das Strukturierwerkzeug (60) angepasst ist, um in Erwiderung auf eine Neigung (δ) des Films (5) in der Schneidenlängsrichtung (AR3) mit der Drehung der Halterung (31) um die erste Achse (38a) in Bezug auf eine Referenzstellung der Schneidenklinge (61a) zu schwenken, wobei die Stellung der Schneidenklinge (61a) in einem Fall, in dem die Schneidenlängsrichtung (AR3) die Bearbeitungsrichtung (AR2) im rechten Winkel in einer waagrechten Ebene schneidet, als die Referenzstellung definiert ist.

2. Strukturiervorrichtung (1) nach Anspruch 1, wobei der Halterungsschwenkbereich (34) in der Lage ist, um eine zweite Achse (40b) senkrecht zu der Bearbeitungsrichtung (AR2) in einer waagerechten Ebene zu drehen.

3. Strukturiervorrichtung (1) nach Anspruch 2, wobei das Strukturierwerkzeug (60) angepasst ist, um die Strukturierung in einer geneigten Stellung in Erwiderung auf die Drehbewegung des Halterungsschwenkbereichs (34) um die zweite Achse (40b) auszuführen.

4. Strukturiervorrichtung (1) nach einem der Ansprüche 1 bis 3, wobei das Strukturierwerkzeug (60) eine Breite (S3) in der Schneidenlängsrichtung (AR3) hat, die größer ist als die Breite (S4) eines Teils (62) des Strukturierwerkzeugs (1), der an der Halterung (31) befestigt ist.

5. Strukturiervorrichtung (1) nach einem der Ansprüche 1 bis 4, wobei das Strukturierwerkzeug (160, 360) ein Durchgangsloch (61b, 361b) hat, das in einem oberen Teil (61, 361) der Schneidenklinge (61a, 361a) ausgebildet ist.

## Revendications

1. Dispositif de placement de motif (1) pour détacher ou retirer partiellement un film (5) formé sur un substrat (4), comprenant :
une unité de support (10) pour supporter un substrat (4) sur lequel un film (5) est formé ;
un outil de placement de motif (60) avec un bord de lame (61a) au niveau d'une partie d'extrémité de pointe de l'outil de placement de motif (60), le bord de lame (61a) s'étendant dans une direction de longueur de lame (AR3) ;
un support (31) pour fixer ledit outil de placement de motif (60) ;
une section d'oscillation de support (34) pour supporter ledit support (31) tout en faisant tourner le support (31) autour d'un premier axe (38a) existant dans un plan comprenant la direction de traitement (AR2) et la direction verticale (Z) ;
une section d'entraînement (70) pour amener ladite section d'oscillation de support (34) à se déplacer par rapport à ladite unité de support (10) ; et
une section de levage (50) pour faire monter et descendre ladite section d'oscillation de support (34) ;
ladite section de levage (50) étant adaptée pour amener ladite section d'oscillation de support (34) à se déplacer pour se rapprocher de ladite unité de support (10) de sorte que ledit bord de lame (61a) dudit outil de placement de motif (60) est en contact de butée avec ledit film (5), et
ladite section d'entraînement (70) étant adaptée pour amener ladite section d'oscillation de support (34) à se déplacer par rapport à ladite direction de traitement (AR2) de sorte que ledit film (5) est modelé par ledit outil de placement de motif (60) dans ladite direction de traitement (AR2),
le dispositif de placement de motif (1) étant **caractérisé en ce que** :
ledit outil de placement de motif (60) est adapté pour osciller en réponse à une inclinaison (δ) dudit film (5) dans ladite direction de longueur de lame (AR3) avec la rotation dudit support (31) autour dudit premier axe (38a) par rapport à une posture de référence dudit bord de lame (61a), dans lequel la posture dudit bord de lame (61a) dans le cas dans lequel ladite direction de longueur de lame (AR3) traverse ladite direction de traitement (AR2) en angle droit dans un plan horizontal, est définie comme étant la posture de référence.

2. Dispositif de placement de motif (1) selon la revendication 1, dans lequel ladite section d'oscillation de support (34) peut pivoter autour d'un second axe (40b) perpendiculaire à ladite direction de traitement (AR2) dans un plan horizontal.

3. Dispositif de placement de motif (1) selon la revendication 2, dans lequel ledit outil de placement de motif (60) est adapté pour réaliser ledit placement de motif dans une posture inclinée en réponse au mouvement pivotant de ladite section d'oscillation de support (34) autour dudit second axe (40b).

4. Dispositif de placement de motif (1) selon l'une quelconque des revendications 1 à 3, dans lequel ledit outil de mise en place de motif (60) a une largeur (S3) dans ladite direction de longueur de lame (AR3) supérieure à la largeur (S4) de la partie (62) dudit outil de placement de motif (1) fixée audit support (31).

5. Dispositif de placement de motif (1) selon l'une quelconque des revendications 1 à 4, dans lequel ledit outil de placement de motif (160, 360) a un trou débouchant (61b, 361b) formé dans une partie supérieure (61, 361) dudit bord de lame (61a, 361a).
